(19) **Europäisches Patentamt**

**European Patent Office**

**Office européen des brevets**

(11) Veröffentlichungsnummer: **0 430 057 A1**

(12) # EUROPÄISCHE PATENTANMELDUNG

(21) Anmeldenummer: 90122271.1

(22) Anmeldetag: 22.11.90

(51) Int. Cl.⁵: **H05K 5/00**

(30) Priorität: 24.11.89 DE 3938865

(43) Veröffentlichungstag der Anmeldung:
**05.06.91 Patentblatt 91/23**

(84) Benannte Vertragsstaaten:
**AT BE DE ES FR GB IT SE Patentblatt**

(71) Anmelder: **Kabelwerke Reinshagen GmbH**
**Reinshagenstrasse 1**
**W-5600 Wuppertal 21(DE)**

(72) Erfinder: **Osthoff, Hans-Günter, Dipl.-Ing.**
**Mönninghofer Weg 40**
**W-5820 Gevelsberg(DE)**
Erfinder: **Pauss, Ludwig**
**Bergstrasse 28**
**W-4300 Essen 18(DE)**

(74) Vertreter: **Priebisch, Rüdiger, Dipl.-Ing.,**
**Dipl.-Wirtsch.-Ing. (FH)**
**Kabelwerke Reinshagen GmbH**
**Patentabteilung Reinshagenstrasse 1**
**W-5600 Wuppertal 21(DE)**

(54) **Elektrische Steuereinrichtung mit Gehäuse, insbesondere Modul für ein dezentrales Verdrahtungssystem.**

(57) Bei einer elektrischen Steuereinrichtung werden zwei parallel übereinanderliegende Leiterplatten im Gehäuse verwendet, die stellenweise miteinander verbunden sind und an ihrem Plattenrand Kupplungsteile tragen, die in einer Frontwand des Gehäuses nach der Montage zu liegen kommen. Um eine kompakte, schnell zusammenbaubare und wieder zerlegbare Steuereinrichtung zu entwickeln wird vorgeschlagen, beide Platten mit eigenen Kupplungsteilen auszurüsten, womit zwei eigenständige Baugruppen erlangt werden. Die eine Baugruppe umfaßt auch eine einstückig mit den Kupplungsteilen ausgebildete Frontwand des späteren Gehäuses und eine neben den Kupplungsteilen darin vorgesehene fensterartige Öffnung. Die beiden Baugruppen werden über eine Einrenkbewegung zu einer Baueinheit zusammengefügt, wo die Kupplungsteile der einen Baugruppe die Öffnung in der Frontwand der anderen Baugruppe verschließen. Der entstehenden Trennfuge zwischen diesen aneinanderstoßenden Kupplungsteilen ist eine Muffe mit einer Ringdichtung vorgeschaltet. Außerdem besitzen die Leiterplatten zwischen sich Kontaktstifte und Kontaktaufnahmen, die bei der Einrenkverbindung miteinander in Eingriff kommen.

FIG. 1

# ELEKTRISCHE STEUEREINRICHTUNG MIT GEHÄUSE, INSBESONDERE MODUL FÜR EIN DEZENTRALES VERDRAHTUNGSSYSTEM

Die Erfindung richtet sich auf eine elektrische Steuereinrichtung der im Oberbegriff des Anspruches 1 angegebenen Art. Bei der bekannten Steuereinrichtung waren die beiden Leiterplatten an zwei gegenüberliegenden Plattenkanten durch flexible Leitungen miteinander verbunden. Nach der Bestückung wurden die Leiterplatten übereinander geklappt, indem die elektrischen Verbindungen als Scharnier wirkten. Am einen Rand der Leiterplatte befanden sich elektrische Kupplungsteile, die beim Einbau dieser Einrichtung in ein Gehäuse an einer Frontwand zu liegen kamen und dort durch Wandöffnungen für das Einkuppeln von komplementären Gegenkupplungsteilen dienten, die an elektrischen Verbindungsleitungen saßen.

Die Herstellung und Handhabung der bekannten Steuereinrichtung bei ihrem Einbau in das Gehäuse waren umständlich und zeitaufwendig. Es lag auch keine ausreichende Abdichtung zwischen dem Gehäuse und der Steuereinrichtung vor; das machte den Einsatz im Kraftfahrzeugbau problematisch.

Der Erfindung liegt die Aufgabe zugrunde, eine einfach gebaute, kompakte Steuereinrichtung der im Oberbegriff des Anspruches 1 genannten Art zu entwickeln, die schnell zusammengebaut und wieder zerlegt werden kann und sich dabei durch große Dichtigkeit im eingebauten Gehäuse auszeichnet. Dies wird erfindungsgemäß durch die im kennzeichen des Anspruches 1 angeführten Maßnahmen erreicht, denen folgende besondere Bedeutung zukommt.

Jede Leiterplatte trägt ihre eigenen Kupplungsteile, weshalb eine einwandfreie elektrische Verbindung zu den jeweiligen Leiterbahnen besteht. Die künftige Frontwand des Gehäuses ist aber von vorneherein fest mit den Kupplungsteilen der einen Leiterplatte verbunden und sieht durch ihre angrenzende Öffnung bereits jene Stellen vor, die im Montagefall für die Position der an der anderen Leiterplatte befindlichen Kupplungsteile bestimmt sind. Es liegen also zwei Baugruppen vor dem Zusammenbau der Steuereinrichtung vor, die jeweils aus ihrer Leiterplatte mit eigenen Kupplungsteilen bestehen, wobei zu der einen Baugruppe auch die Frontwand gehört. Die Montage dieser beiden Baugruppen erfolgt durch eine einrenk-artige Bewegungsfolge, die sich aus einer platten-parallelen Einsteckbewegung und aus einer anschließenden dazu vertikalen Einrastbewegung zusammensetzt. Bei der anfänglichen Einsteckbewegung werden die beiden Baugruppen mit ihren Leiterplatten zwar in Abstand, aber parallel zueinander bewegt, bis es zwischen der Frontwand einerseits und den gegeneinanderbewegten Kupplungsteilen der zweiten Platte andererseits zu Berührungen kommt. In dieser Anschlagposition sind Rastelemente zwischen der Frontplatte und den herangeführten Kupplungsteilen in vertikaler Ausrichtung und kommen durch eine senkrecht zur Plattenebene erfolgende Einrastbewegung miteinander in Eingriff. Während dieser Einrastbewegung kommt es auch zu einer Kontaktierung der beiden Leiterplatten über Stifte und Aufnahmen, die vorausgehend, bei der platten-parallelen Einsteckbewegung, sich noch in Abstand zueinander befanden. Die Einrastbewegung sichert somit nicht nur die Aneinanderlage der beiden Kupplungsteile, sondern auch die elektrisch einwandfreie Kontaktierung der zugehörigen Leiterplatten, ist also mechanisch und elektrisch wirksam.

Die durch die Einrenkbewegung miteinander elektrisch und mechanisch verbundenen Baugruppen bilden eine zusammenhängende Baueinheit, die, zusammen mit der Frontwand, beim Einbau in das übrige Gerätegehäuse als ganzes gehandhabt wird. Trotz der Berührungsfuge zwischen den beiden Kupplungsteil-Hälften dieser Baueinheit ist eine mediendichte Verbindung durch die der gemeinsamen Öffnung vorgeschaltete Muffe erreicht. Die Muffe umschließt ringförmig die Trennfuge und die beiden aneinandergefügten Kupplungsteil-Hälften. Die dort befindliche Ringdichtung sorgt für einen mediendichten Abschluß, wenn die Gegenkupplungshälfte in die Muffe eingeführt wird und im Muffeninneren mit der Ringdichtung zusammenwirkt. Die erfindungsgemäße Baueinheit ist äußerst kompakt. Diese kompakte Bauweise ergibt sich, weil die beiden Kupplungsteile im Bereich der Öffnung der Frontwand so eng aneinander zu liegen kommen, daß sie gleichsam zwei Hälften einer gemeinsamen Kupplung bilden. Sie wirken im Kupplungsfall auch gemeinsam mit einem einzigen Gegenkupplungsteil zusammen. Es wäre auch möglich, die erfindungsgemäße Baueinheit aus mehr als zwei Baugruppen zusammenzubauen, die jeweils eigene Leiterplatten und Kupplungsteile aufweisen.

Für den leichten Zusammenbau und die Mediendichtigkeit empfiehlt es sich, dem Gehäuse den topfförmigen Aufbau gemäß Anspruch 5 zu geben. Auch die Frontplatte sollte dabei gemäß Anspruch 6 eine Dichtung erhalten. Der Zusammenhalt zwischen dem topfförmigen Gehäuse und der Baueinheit läßt sich am einfachsten und sichersten durch die Maßnahme des Anspruches 7 erreichen, ohne daß dies die Abdichtwirkung beeinträchtigt. Der Versatz der Baueinheit mit ihren beiden Leiterplatten an der Frontscheibe kann gut zur Anordnung von Kühlkörpern im Gehäuseinneren gemäß Anspruch 8 genutzt werden. Dies empfiehlt sich insbesondere dann, wenn die eine Platte als Lastplatine im Sinne des Anspruches 9 ausgebildet ist, weil diese einer Wärmekontaktierung mit dem Kühlkörper des Gehäuses bedarf.

Um den Zusammenhalt zwischen den beiden Kupplungsteil-Hälften zu verbessern empfiehlt es sich, Vorsprünge und Aussparungen gemäß Anspruch 2 vorzusehen. Aus Stabilitätsgründen sollte man diese als Rippen und Nuten ausbilden.

In manchen Anwendungsfällen ist die Frontwand ausreichend groß bemessen, so daß Bereiche frei bleiben. Diese können, gemäß Anspruch 3, bedarfsweise dazu genutzt werden, um weitere Kupplungsteile anzuordnen, die lediglich zu dieser mit der Frontwand ausgerüsteten Leiterplatte gehören. Alternativ oder zusätzlich wäre es aber auch möglich, an der Frontwand, gemäß Anspruch 4, Öffnungen vorzusehen, wo zusätzliche, lediglich an der anderen Leiterplatte befindliche Kupplungsteile in der erfindungsgemäßen Weise zu liegen kommen, ohne daß eigene Kupplungsteile an der diesseitigen Leiterplatte vorgesehen sind.

Weitere Maßnahmen und Vorteile der Erfindung ergeben sich aus der nachfolgenden Beschreibung und den Zeichnungen. Die Erfindung richtet sich dabei auf alle daraus entnehmbaren neuen Merkmale und Merkmalskombinationen, auch wenn diese nicht ausdrücklich in den Ansprüchen angeführt sein sollten. In den Zeichnungen ist die Erfindung in einem Ausführungsbeispiel dargestellt. Es zeigen:

Fig. 1 in einer perspektivischen Darstellung die beiden Baugruppen der Steuereinrichtung vor der Montage der erfindungsgemäßen Baugruppe, wobei die Bewegungsfolge der Baugruppe bei der Montage mit angedeutet ist,

Fig. 2 eine Schnittansicht durch das Gehäuse mit darin eingebauter Steuereinrichtung nach der Erfindung und mit einem an einer Stelle eingeführten Gegenkupplungsteil einer elektrischen Kupplung,

Fig. 3 die Innenansicht eines zu der einen Baugruppe der Erfindung gehörenden Bauteils vor dessen Komplettierung durch die Leiterplatte und Kontaktglieder,

Fig. 4 eine versprungene Schnittansicht durch den Bauteil von Fig. 3 längs der dortigen Schnittlinie IV-IV,

Fig. 5 eine Querschnittansicht durch den Bauteil von Fig. 3 längs der dortigen Schnittlinie V-V,

Fig. 6 und 7 in Vorderansicht bzw. Draufsicht die zu der anderen Baugruppe gehörenden Bauteile nach ihrer Verbindung mit der zugehörigen Leiterplatte, aber noch ohne Kontaktglieder, und

Fig. 8 eine der Fig. 3 entsprechende Innenansicht auf die aus den beiden Baugruppen vervollständigte Baueinheit unter Weglassung der beiden Leiterplatten sowie der Kontaktglieder.

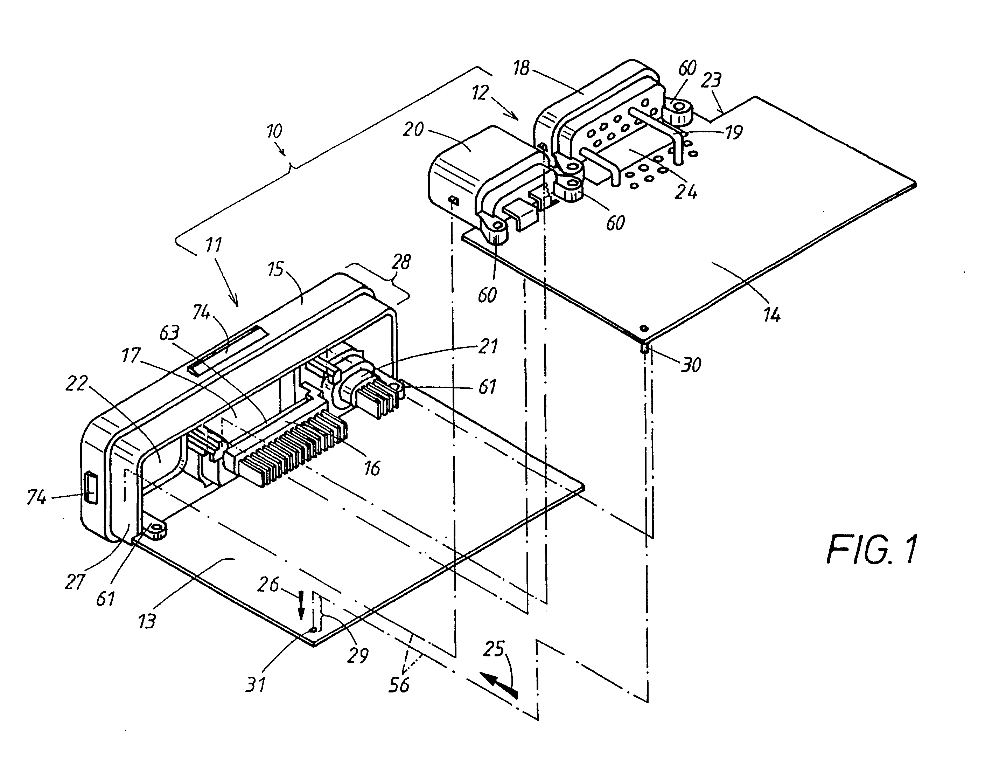

Die elektrische Steuereinrichtung besteht aus einer besonderen Baueinheit 10, die sich durch eine Einrenkbewegung der beiden aus Fig. 1 ersichtli chen Baugruppen 11, 12 montieren läßt. Jede Baugruppe 11, 12 umfaßt eine Leiterplatte mit schaltungsspezifischen Leiterbahnen und elektrischen Bauelementen, die nicht näher gezeigt sind. Während die Leiterplatte 14 der Baugruppe 12 eine Lastplatine darstellt, die im Betriebsfall an ihren Bauelementen eine hohe Wärmeentwicklung entstehen läßt, ist die Leiterplatte 13 der anderen Baugruppe 11 als Logikplatine ausgebildet mit entsprechend geringer Wärmeentwicklung im Betriebsfall.

Für das spätere Gerätegehäuse besitzt lediglich die eine Leiterplatte 13 eine als Gehäusedekkel fungierende Frontplatte 15, in welche ein Satz von Kupplungsteilen 16 integriert ist, die mit den Leiterbahnen dieser Platte 13 verbunden sind. Unmittelbar neben diesen Kupplungsteilen ist in der Frontplatte 15 eine Öffnung 17 vorgesehen, in welche nach vollzogener Montage ein weiterer Satz 18 von Kupplungsteilen eingreift, die über feste Verbindungen 19 mit den Leiterbahnen der Lastplatine 14 von der anderen Baugruppe 12 zusammenhängen. Diese beiden Kupplungssätze 16, 18 bilden also gleichsam zwei Hälften eines im Montagefall nachträglich einander ergänzenden Kupplungsteils.

Beide Baugruppen 11, 12 besitzen darüber hinaus auch noch zusätzliche, im Montagefall selbständig zu liegen kommende Kupplungsteile 20, 21, die in seitlichem Versatz zueinander angeordnet sind und damit an unterschiedlichen Stellen der Frontplatte 15 sich im Montagefall befinden. So besitzt die Frontplatte 15 zur Aufnahme der weiteren Kupplungsteile 20 der anderen Baugruppe 12 eine eigene Öffnung 22, während die an der Baugruppe 11 befindlichen zusätzlichen Kupplungsteile 21 unmittelbar in die Frontplatte 15, nämlich insbesondere einstückig, integriert sind, während in der anderen Baugruppe 12 an dieser Stelle die dortige Lastplatine 14 einen Randausbruch 23 aufweist. Ein ähnlicher Randausbruch 24 befindet sich an jener Stelle der Lastplatine 14, wo im Montagefall die elektrischen Verbindungen des zur anderen Baugruppe 11 gehörenden Kupplungsteils 16 zu liegen kommen. Die Verbindung der diversen Kupplungsteile bzw. der Frontplatte 15 an ihren Leiterplatten 13, 14 erfolgt durch eine Schar von Flanschen 60 bzw. 61, die über eine Nietbefestigung mit der Platte 13 bzw. 14 zusammenhängen.

Der Zusammenbau der Baueinheit 10 aus diesen beiden Baugruppen 11, 12 erfolgt über eine zweistufige Bewegungsfolge, die in Fig. 1 durch Strichpunkt-Linien 56 und Pfeile 25, 26 gekennzeichnet sind. Anfangs wird die Baugruppe 12 zwar mit ihrer Lastplatine 14 parallel zur Logikplatine 13 der anderen Baugruppe 11 gebracht, aber demgegenüber soweit nach hinten gesetzt, daß die freien Enden der genannten Kupplungsteile 20, 18 an der Baugruppe 12 noch vor dem verengten Absatz 27 eines abgesetzten Umfangsflansches 28 der Frontplatte 15 zu liegen kommen. In dieser Ausgangsposition der Montage befinden sich die beiden Platinen 13, 14 in einem Höhenabstand 29, der jedenfalls größer als die herausragende Länge einer Schar von Kontaktstiften 30 ausgebildet ist, denen bei der anderen Platine 13 komplementäre Kontaktaufnahmen 31 zugeordnet sind. In Fig. 1 ist lediglich ein einziges Paar von Kontakt-Stiften und -Aufnahmen 30, 31 vorgesehen, doch versteht es sich, daß hierzu eine Vielzahl solcher Kontaktverbindungen vorbereitet ist, entsprechend der gewünschten elektrischen Schaltung zwischen Last- und Logikplatine 13, 14 im endgültigen Montagefall.

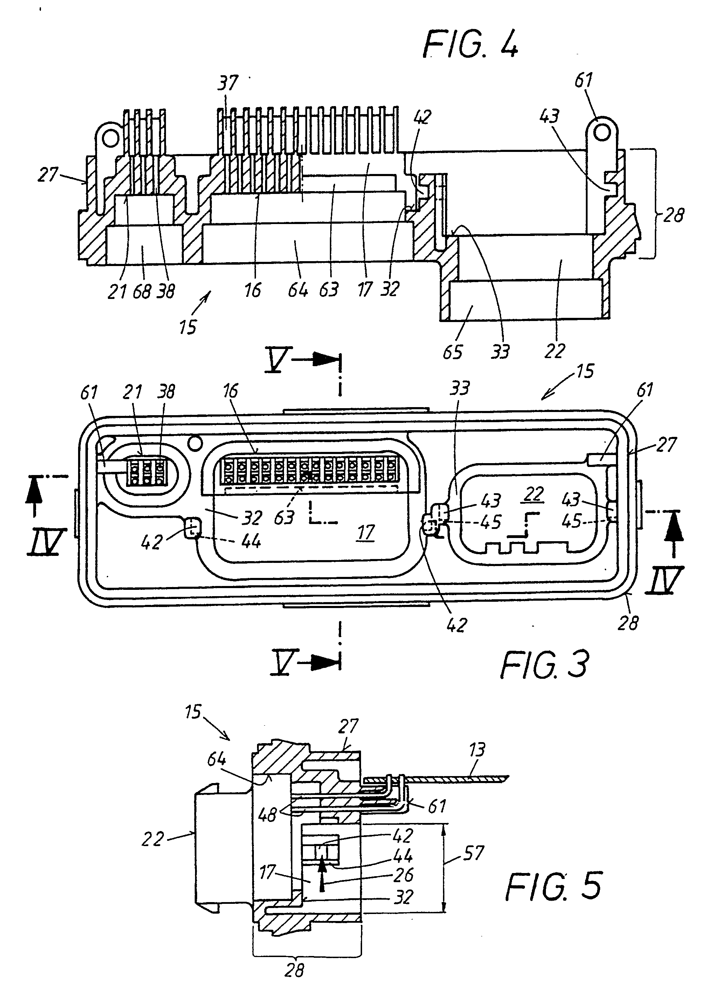

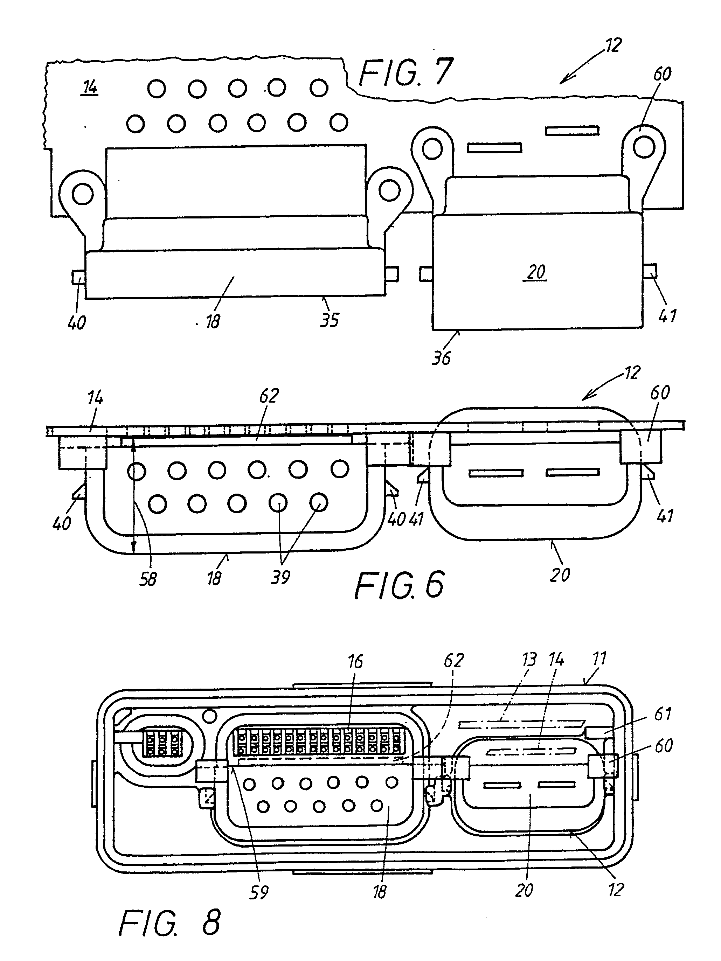

Ausgehend von dieser Ausgangsstellung wird nun zunächst eine Einsteckbewegung im Sinne des Pfeils 25 ausgeübt, wo die Baugruppe 12 mit ihrer Lastplatine 14 parallel zur Logikplatine 13 der anderen Baugruppe 11 bewegt wird, bis schließlich an den am besten aus Fig. 4 ersichtlichen Anschlägen 32, 33 der Frontplatte 15 die in Fig. 7 erkennbaren Gegenanschläge 35, 36 an den Kupplungsteilen 18 bzw. 20 der anderen Baugruppe 12 zur Anlage kommen. Die Kupplungsteile 18, 20 besitzen als Vorsprünge 40 bzw. 41 gestaltete Rastelemente, die auch anschlagwirksam werden können im Bereich von komplementären Rastelementen, nämlich Rastvertiefungen 42, 43, welche, gemäß Fig. 3 bis 5, sowohl im Bereich des Kupplungsteils 16 an der nebengeordneten Öffnung 17 als auch an der zusätzlichen Öffnung 22 der Frontplatte 15 vorgesehen sind. Am Ende dieser Einsteckbewegung 25 befinden sich auch die beidseitigen Kontaktstifte und -Aufnahmen 30, 31 der beiden Platten 13, 14 in paarweiser Ausrichtung. Jetzt folgt eine senkrecht zur Plattenebene vollziehbare Einrastbewegung im Sinne des Pfeils 26 von Fig. 1, die dadurch zum Abschluß kommt, daß die beidseitigen Rastelemente 40 bis 43 paarweise ineinander schnappen, wie auch die erwähnten Kontakt-Stifte und Aufnahmen 30, 31 miteinander in Eingriff kommen. Die Einrastbewegung der Elemente 40 bis 43 vollzieht sich in aus Fig. 5 ersichtlichem Einführfaden, die dort durch den Pfeil 26 veranschaulicht und den Rastvertiefungen 42 zugeordnet sind, was sinngemäß auch für 43 gilt. Vor diesen Rastvertiefungen 42, 43 befinden sich Rastlappen 44 bzw. 45, die bei dieser Einrastbewegung 26 mit der geneigten Schulter der ein Sägezahnprofil aufweisenden Rastvorsprünge 40 bzw. 41 zusammenwirken, bis die steile Flanke dieser Vorsprünge 40, 41 hinter den Rastlappen 44, 45 einschnappt.

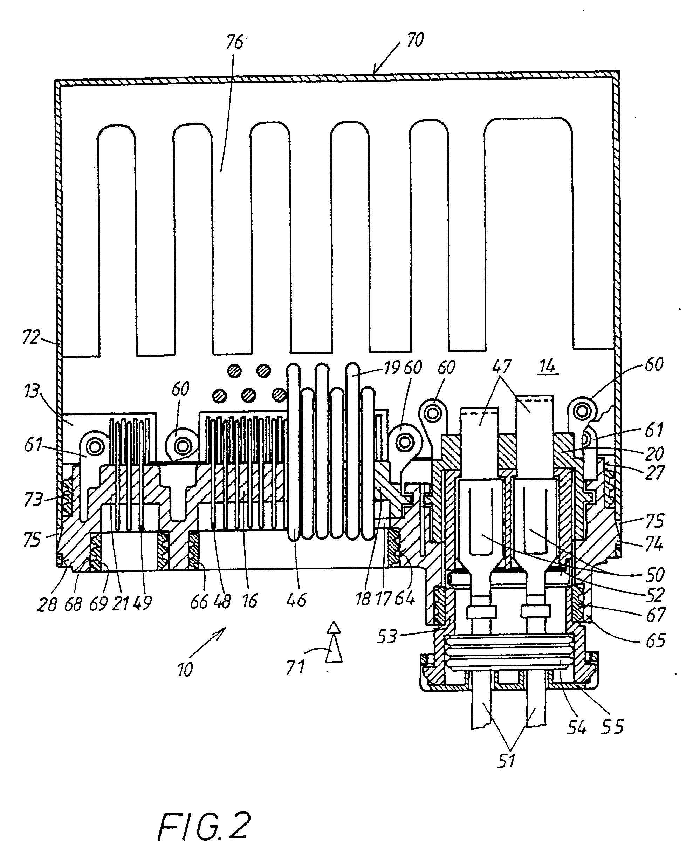

In Fig. 3 und 4 sowie 6 und 7 sind die jeweiligen Kupplungsteile lediglich durch ihre jeweiligen Isolationskörper repräsentiert, in welchen Kammern 37, Bohrungen 38 bzw. Löcher 39 vorgesehen sind, um die aus Fig. 2 und 5 ersichtlichen zugehörigen Kontaktglieder 46, 47, 48, 49 aufnehmen zu können. Diese Kontaktglieder 46 bis 49 sind im vorliegenden Fall ausnahmslos Kupplungsstecker, die im Gebrauchsfall mit Kupplungshülsen 50 in Eingriff kommen, an welche die weiterführenden elektrischen Leitungen 51 angeschlossen sind. In Fig. 2 ist lediglich für den Kupplungsteil 20 der komplementäre Gegenkupplungsteil 52 dargestellt, in welchem die Hülsen 50 integriert sind und welcher eine abgesetzte Manschette 53 besitzt. Die Leitungen 51 können in der entsprechend abgesetzten Manschettenöffnung mittels einer Scheibendichtung 54 mediendicht positioniert sein, die von einem äußeren Manschettendeckel 55 festgehalten wird.

Bei der Einrastbewegung 26, welche die letzte Phase der strichpunktiert in Fig. 1 angedeuteten Einrenkung 56 bildet, muß eine am besten aus Fig. 5 ersichtliche Öffnungsweite 57 an der Frontplatten-Öffnung 17 vorliegen, die mindestens um die Strecke der geschilderten Einrastbewegung 26 größer ist als dem aus Fig. 6 ersichtlichen Außenmaß 58 des dort zu positionierenden Kupplungsteils 18 entspricht. Die herausragenden Enden der aus Fig. 2 ersichtlichen Kontaktglieder 48 müssen in den Freiraum der Öffnung 17 treten, bevor sie die vertikale Einrastbewegung 26 vollziehen. Entsprechende Maßverhältnisse müssen auch in der Öffnungsweite der zum zusätzlichen Kupplungsteil 20 gehörenden weiteren Öffnung 22 in der Frontplatte 15 vorliegen.

Die fertig vollzogene Montage der Kupplungsteile läßt sich am besten aus Fig. 8 entnehmen, wo allerdings, aus Gründen der Deutlichkeit, die vorbeschriebenen Kontaktglieder 46 bis 49 ebenso weggelassen worden sind, wie die Leiterplatten 13, 14, deren Position an den Befestigungsflanschen 60, 61 in Fig. 8 strichpunktiert veranschaulicht ist. Zwischen den beiden Kupplungsteilen 16, 18 entsteht dabei eine Trennfuge 59, an welcher die beiden Kupplungsteile 18, 16 zusätzlich noch formschlüssig ineinandergefügt sind, nämlich durch eine am einen Kupplungsteil 18 vorgesehene Halterippe 62, gemäß Fig. 6, und einer aus Fig. 3 und 4 ersichtlichen zugehörigen Haltenut 63. Dadurch ist eine platten-parallele Herausziehbewegung der beiden Baugruppen 11, 12 entgegen dem Pfeil 25 von Fig. 1 nicht mehr möglich. Dies wird im übrigen auch durch die beschriebenen Rastelemente 40 bis 45 ausgeschlossen, die ausweislich der Fig. 2 ein Nut-Feder-Profil aufweisen.

Vor der Öffnung 17, aber auch vor der Zusatzöffnung 22, befindet sich eine umlaufende Muffe 64 bzw. 65, wie aus den Fig. 4 und 5 zu ersehen ist. sie ist den genannten Trennfugen 59 vorgeschaltet und dient zur Aufnahme einer aus Fig. 2 ersichtlichen Ringdichtung 66 bzw. 67. Eine entsprechende Muffe 68 mit einer analogen Ringdichtung 69 befindet sich schließlich auch bei dem zusätzlichen isolierten Kupplungsteil 21 gemäß Fig. 2 und 4. Wie anhand des in Fig. 2 erkennbaren Gegenkupplungsteils 52 ersichtlich ist, kommt es im Kupplungsfall zu einem mediendichten Abschluß im Bereich der Ringdichtungen 69, 66, 67, wodurch Trennfugen 59 zwischen den aneinanderstoßenden Kupplungsteil-Hälften 16, 18 nach außen wirksam abgedichtet sind.

Durch die geschilderte zweistufige Einrenkbewegung 25, 26 lassen sich die beiden Baugruppen 11, 12 schnell zu einer Baueinheit 10 montieren. Im Benutzungsfall liegt jedenfalls eine in sich zusammenhängende, kompakte Baueinheit 10 aus den diversen Kupplungsteilen 16 bis 21 vor mit sehr dicht übereinanderliegenden Leiterplatten 13, 14, wie aus den Bestandteilen in Fig. 8 erkennbar ist. Diese Baueinheit 10 wird als ganzes gehandhabt, um sie in ein aus Fig. 2 ersichtliches topfförmiges Gehäuse 70 im Sinne des Pfeils 41 einführen zu können. Das Topfgehäuse 70 besitzt eine Seitenwand 72, deren Innenfläche mit dem eingangs erwähnten bei 27 abgesetzten Umfangsring 28 der Frontplatte 15 zusammenwirkt. Im Absatzbereich 27 kommt dabei, wie aus Fig. 2 erkennbar ist, eine umlaufende Ringdichtung 73 zu liegen, die nach der Einführung 71 der Baueinheit 10 für einen mediendichten Abschluß sorgt. Die ganze Front platte 15 ist damit eine Art Topfdeckel, der mittels der Ringdichtung 73 wie ein Stopfen die Öffnung des Topfgehäuses 70 verschließt. Diese Abschlußlage ist schließlich auch dadurch gesichert, daß im Umfangsbereich 28 Verschlußnasen 74 an der Frontplatte 15 vorgesehen sind, welche im Einführfall in Durchbrüche 75 der Topfseitenwand 72 eingreifen.

Im Topfinneren ist dabei der in Fig. 2 ersichtliche stark gegliederte Kühlkörper 76 angeordnet, der im Einführfall in Flächenberührung mit der Lastplatine 14 der Baueinheit 10 kommt und daher über das Topfgehäuse 70 für eine gute Wärmeableitung sorgt. Das Gehäusematerial ist seinerseits gut temperaturleitend und besteht z. B. aus Aluminium.

Bezugszeichenliste:

10 Baueinheit aus 11, 12
11 Baugruppe
12 Baugruppe
13 Leiterplatte, Logikplatine
14 Leiterplatte, Lastplatine
15 Frontwand
16 ein Satz von Kupplungsteilen, Kupplungshälfte
17 Öffnung in 15
18 Satz von Kupplungsteilen
19 elektrische Verbindung von 18, 14
20 weiterer Kupplungsteil bei 12
21 zusätzlicher Kupplungsteil bei 11
22 zusätzliche Öffnung in 15
23 Randausbruch von 14
24 Randausbruch von 14
25 Einsteckbewegungs-Pfeil
26 Einrastbewegungs-Pfeil, Einführpfad
27 Absatz in 28
28 Umfangsflansch
29 Höhenabstand bei Einsteckbewegung
30 Kontaktstift bei 14
31 Kontaktaufnahme bei 13
32 Anschlag bei 16 von 11
33 Anschlag bei 22 von 11
35 Gegenanschlag an 12
36 Gegenanschlag an 12
37 Kammer von 16
38 Bohrung von 21
39 Loch von 18
40 Rastvorsprung von 18 bei 12
41 Rastvorsprung von 20 bei 12
42 Rastvertiefung von 15 bei 16
43 Rastvertiefung von 15 bei 22
44 Rastlappen bei 42
45 Rastlappen bei 43
46 Kontaktglied von 12
47 Kontaktglied von 12
48 Kontaktglied von 11
49 Kontaktglied von 11
50 Kupplungshülse
51 elektrische Leitungen
52 Gegenkupplungsteil
53 Manschette
54 Scheibendichtung
55 Manschettendeckel
56 Einrenkbewegung, Montagefolge
57 Öffnungsweite von 17
58 Außenmaß von 18
59 Trennfuge zwischen 16, 18
60 Befestigungsflansch an 14
61 Befestigungsflansch an 13
62 Halterippe an 18
63 Haltenut an 16
64 Muffe von 17
65 Muffe von 22
66 Ringdichtung in 64
67 Ringdichtung in 65
68 Muffe bei 21
69 Ringdichtung in 68
70 topfförmiges Gehäuse, Topfgehäuse
71 Einführ-Pfeil von 10

72 Topfseitenwand
73 Ringdichtung bei 27, 28
74 Verschlußnase von 15
75 Durchbruch in 72
76 Kühlkörper in 70

**Ansprüche**

1. Elektrische Steuereinrichtung mit Gehäuse, insbesondere Modul für ein dezentrales Verdrahtungssystem vorzugsweise im Kraftfahrzeugbau,
mit mindestens zwei parallel übereinanderliegenden Leiterplatten (13, 14) im Gehäuse, deren Leiterbahnen stellenweise miteinander verbunden sind und mit am einen Plattenrand angeordneten, an die Leiterbahnen angeschlossenen einen Kupplungsteilen (16, 18) einer durch komple mentäre Gegenkupplungsteile (52) im Kupplungsfall ergänzten zweiteiligen elektrischen Kupplung, wie patrizenförmigen Kupplungssteckern,
wobei die Kupplungsteile in einer Frontwand (15) des Gehäuses (70) sitzen und im Kupplungsfall abdichtwirksam mit den Gegenkupplungsteilen (52), wie Kupplungshülsen (50), kontaktiert sind,
**dadurch gekennzeichnet,** daß jede der beiden Leiterplatten (13, 14) ihre eigenen Kupplungsteile (16, 18) trägt,
die Kupplungsteile (16) der einen Leiterplatte (13) zugleich Träger der damit fest verbundenen, insbesondere damit einstückigen Frontwand (15) des Gehäuses (70) sind sowie, wenigstens bereichsweise, eine unmittelbar an die angrenzende Öffnung (17) mit Anschlägen (32) zum Einstecken (25) der an der anderen Leiterplatte (14) befestigten Kupplungsteile (18) zwar in einem Plattenabstand (29) aber zueinander plattenparallel aufweisen, bis jene anderen Kupplungsteile (18) an die Anschläge (32) stoßen und die Einsteckbewe gung (25) stoppen,
daß die Frontplatte (15) im Öffnungsbereich einerseits und die angrenzenden Stellen der anderen Kupplungsteile (18) andererseits zueinander komplementäre Rastelemente (40, 42) tragen, die zwar bei der plattenparallelen Einsteckbewegung (25) zueinander höhenversetzt (29) sind, aber in Anschlagposition miteinander vertikal ausgerichtete Einführpfade für eine senkrecht zur Plattenebene (13, 14) vollziehbare Einrastbewegung (26) aufweisen,
und die Öffnung (17) eine Muffe (64) zur Aufnahme einer umlaufenden Ringdichtung (66) besitzt, die, in Einsteckrichtung (25) gesehen, der Trennfuge (59) zwischen den beiden Kupplungsteilen (16, 18) nachgeschaltet ist sowie diese ringförmig umschließt,
und daß zwischen den Leiterbahnen der beiden Leiterplatten (13, 14) stellenweise Kontaktstifte (30) einerseits und Kontaktaufnahmen (31) andererseits sitzen, die gegenüber dem Plattenabstand (29) bei der Einsteckbewegung (25) der Leiterplatten (13, 14) kürzer ausgebildet sind, in der Anschlagposition der Kontaktteile (16, 18) miteinander fluchten und bei der vertikalen Einrastbewegung (26) miteinander kontaktierbar sind.

2. Steuereinrichtung nach Anspruch 1, dadurch gekennzeichnet, daß an der Trennfuge (59) die an der Frontwand (15) sitzenden Kupplungsteile (16) der einen Leiterplatte (13) einerseits und die einrastbaren Kupplungsteile (18) der anderen Platte (14) andererseits zusammenwirkende Vorsprünge und Aussparungen, wie eine Halterippe (62) und eine Haltenut (63), tragen,
die gegenüber dem Plattenabstand (29) bei der Einsteckbewegung (25) der Leiterplatten (13, 14) niedriger ausgebildet sind, in Anschlagposition miteinander fluchten und bei der vertikalen Einrastbewegung (26) in Eingriff kommen.

3. Steuereinrichtung nach Anspruch 1 oder 2, dadurch gekennzeichnet, daß die Frontwand (15) weitere, an ihrer Leiterplatte (13) angeschlossene Kupplungsteile (21) besitzt, denen keine einsteckbaren Kupplungsteile an der anderen Leiterplatte (14) zugeordnet sind und die eine eigene Muffe (68) mit zugehöriger Ringdichtung (69) besitzt.

4. Steuereinrichtung nach einem oder mehreren der Ansprüche 1 bis 3, dadurch gekennzeichnet, daß die Frontwand (15) an einer von Kupplungsteilen ihrer Leiterplatte (13) freien Stelle eine weitere Öffnung (22) mit eigenen Rastelementen (43) sowie einer Muffe (65) mit zugehöriger Ringdichtung (67) besitzt
und der Öffnung (22) an der anderen Leiterplatte (14) plattenparallel einsteckbare (25) sowie vertikal einrastbare (26) zusätzliche Kupplungsteile (20) mit Gegenrastelementen (41) zugeordnet sind.

5. Steuereinrichtung nach einem oder mehreren der Ansprüche 1 bis 4, dadurch gekennzeichnet, daß im Einsteck- sowie Einrastfall die beiden Leiterplatten (13, 14) mit ihren Kupplungsteilen (16, 21; 18, 20) und der Frontwand (15) eine vormontierte Baueinheit (10) bilden, die als ganzes (10) in ein topfförmiges Gehäuse (70) einführbar (71) ist, wobei die Frontwand (15) die Topföffnung verschließt.

6. Steuereinrichtung nach Anspruch 5, dadurch gekennzeichnet, daß die Frontwand (15) im Umfangsbereich (28) einen Absatz (27) für eine umlaufende Dichtung (73) aufweist, die im Einführfall (71) mit der Topfseitenwand (72) mediendicht zusammenwirkt.

7. Steuereinrichtung nach Anspruch 5 oder 6, dadurch gekennzeichnet, daß die Frontplatte (15) im Umfangsbereich (28) vorspringende Verschlußnasen (74) trägt, die in Einführrichtung (71) gesehen, dem Absatz (27) vorgeordnet sind und im Einführfall in Durchbrüche (75) in der Topfseitenwand (72) eingreifen.

8. Steuereinrichtung nach einem oder mehreren der Ansprüche 5 bis 7, dadurch gekennzeichnet, daß im Einführfall (71) der Baueinheit (10) im Topfinneren befindliche Kühlkörper (76) an der Außenseite ihr einen Leiterplatte (14) in wärmeübertragende Berührung kommen.

9. Steuereinrichtung nach einem oder mehreren der Ansprüche 1 bis 8, dadurch gekennzeichnet, daß die eine, vorzugsweise mit der Frontwand (15) ausgerüstete Leiterplatte (13) eine Logikplatine ist, die elektrische Bauelemente mit im Betriebsfall geringer Wärmeentwicklung trägt, während die andere Leiterplatte (14) eine Lastplatine mit hoher Wärmeentwicklung ist.

FIG. 1

EP 0 430 057 A1

FIG.2

*FIG. 4*

*FIG. 3*

*FIG. 5*

FIG. 7

FIG. 6

FIG. 8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-U-8 430 486 (ROBERT BOSCH)<br>* Seiten 7 - 10; Figuren 1-4 *<br>– – – | 1 | H<br>05 K 5/00 |
| A | US-A-3 904 812 (DAFFRON)<br>* Spalte 4, Zeilen 42 - 65; Figur 4 *<br>– – – | 1 | |
| A | DE-U-8 809 912 (MANNESMANN KIENZLE GMBH)<br>– – – – – | | |

|  | RECHERCHIERTE SACHGEBIETE (Int. Cl.5) |
|---|---|
| | H 05 K<br>H 01 R |

Der vorliegende Recherchenbericht wurde für alle Patentansprüche erstellt

| Recherchenort | Abschlußdatum der Recherche | Prüfer |
|---|---|---|
| Den Haag | 14 März 91 | TOUSSAINT F.M.A. |